# DEMANDE DE BREVET EUROPEEN

(11) **EP 0 540 376 A1**
(43) Date de publication de la demande: **05.05.1993**
(21) Numéro de dépôt: 92402420.1
(22) Date de dépôt: 04.09.1992
(51) Int. Cl.: G01R 11/24, G08B 29/04

(54) **Dispositif pour la détection de l'ouverture d'un appareil**

(30) Priorité: 05.09.1991 FR 9110989
(71) Demandeur: SOCIETE D'APPLICATIONS GENERALES D'ELECTRICITE ET DE MECANIQUE SAGEM, F-75783 Paris Cédex 16 (FR)
(72) Inventeur: Ploix, Olivier, F-75017 Paris (FR)
(74) Mandataire: Bloch, Gérard

(57) **Abrégé**

Le dispositif comporte un boîtier (1) et un capot de fermeture (2) maintenu sur le boîtier par une vis (3). Il est prévu une rondelle (8) autour de la vis (3), une piste résistive (7) et une piste conductrice (6) de détection de la position angulaire de la rondelle, une mémoire pour mémoriser ladite position, un microprocesseur pour comparer la position actuelle de la rondelle (8) et sa position mémorisée et des moyens de signalisation d'une différence entre ladite position actuelle et ladite position mémorisée.

L'invention s'applique aux compteurs électriques.

## Description

La présente invention concerne un dispositif pour la détection de l'ouverture d'un appareil comportant un boîtier et un capot de fermeture maintenu sur le boîtier par un organe de verrouillage tel qu'une vis.

La détection de l'ouverture, éventuellement frauduleuse, d'un tel appareil, par exemple un compteur électrique, s'effectue jusqu'à présent par plombage.

Une telle détection n'est toutefois plus possible lorsque l'agent chargé de relever le compteur n'a pas un accès direct à ce dernier mais effectue le relevage à partir d'un poste central auquel différents compteurs sont reliés par une ligne de transmission.

La présente invention vise à fournir un dispositif permettant de détecter à distance l'ouverture d'un tel appareil.

A cet effet, l'invention a pour objet un dispositif pour la détection de l'ouverture d'un appareil comportant un boîtier et un capot de fermeture maintenu sur le boîtier par un organe de verrouillage tel qu'une vis, caractérisé par le fait qu'il comprend une rondelle agencée pour être disposée autour de l'organe de verrouillage, des moyens de détection de la position angulaire de la rondelle, des moyens de mémorisation de ladite position, des moyens de comparaison entre la position actuelle de la rondelle et sa position mémorisée, et des moyens de signalisation d'une différence entre ladite position actuelle et ladite position mémorisée.

L'invention est par conséquent fondée sur le fait que, lorsque l'on retire le capot de l'appareil, par exemple pour tenter de modifier frauduleusement sa programmation, la position de la rondelle se trouve modifiée lors de la refermeture.

Le dispositif selon l'invention présente l'avantage d'être opérationnel même lorsque l'alimentation électrique de l'appareil est coupée, par exemple lors d'une panne ou après enlèvement des fusibles, puisque la position initiale de la rondelle est mémorisée. Dans ce cas, lors de la remise sous tension, une opération de comparaison entre la position actuelle de la rondelle et sa position mémorisée est effectuée et, dans le cas où une différence est relevée, les moyens de signalisation sont activés.

Ces moyens de signalisation peuvent par exemple être constitués d'une mémoire dans laquelle est enregistré le fait que l'appareil a été ouvert, mémoire à laquelle peut accéder une personne autorisée, par exemple l'agent chargé du relevage dans le cas d'un compteur électrique.

La position d'origine de la rondelle est mémorisée au cours d'un processus d'initialisation, lors de la mise en service de l'appareil ou lors de sa fermeture par une personne autorisée.

Dans un mode de réalisation particulier de l'invention, les moyens de détection comprennent une piste résistive sensiblement circulaire, coaxiale à l'organe de verrouillage et solidaire du boîtier, ladite rondelle étant réalisée en matériau isolant et étant, en position de fermeture de l'appareil, en contact avec ladite piste, des moyens pour établir une tension électrique entre les extrémités de ladite piste résistive, et des moyens de mesure pour mesurer le potentiel d'un point angulairement déterminé de la rondelle en contact avec la piste résistive.

La piste résistive constitue par conséquent un potentiomètre, la position angulaire de la rondelle étant déterminée par le potentiel d'un de ses points particuliers en contact avec cette piste.

Les moyens de mesure peuvent comprendre une piste conductrice coaxiale à, et solidaire de la piste résistive, une barrette conductrice radiale solidaire de la rondelle, agencée pour établir une connexion électrique entre un point de la piste résistive et un point de la piste conductrice, et des moyens pour déterminer la différence de potentiel entre la piste conductrice et une extrémité de la piste résistive.

Afin de rendre pratiquement impossible la remise en place du capot avec la rondelle dans sa position d'origine, on peut prévoir une deuxième rondelle en contact avec la première rondelle pour établir un frottement aléatoire lors de la rotation de l'organe de verrouillage.

Les pistes résistives et conductrices peuvent être formées sur un circuit imprimé portant en outre les différents composants électroniques nécessaires au traitement de l'information.

On décrira maintenant, à titre d'exemple non limitatif, un mode de réalisation particulier de l'invention, en référence aux dessins schématiques annexés dans lesquels :
- la figure 1 est une vue en coupe d'un dispositif selon l'invention, et
- la figure 2 représente le montage électronique utilisé.

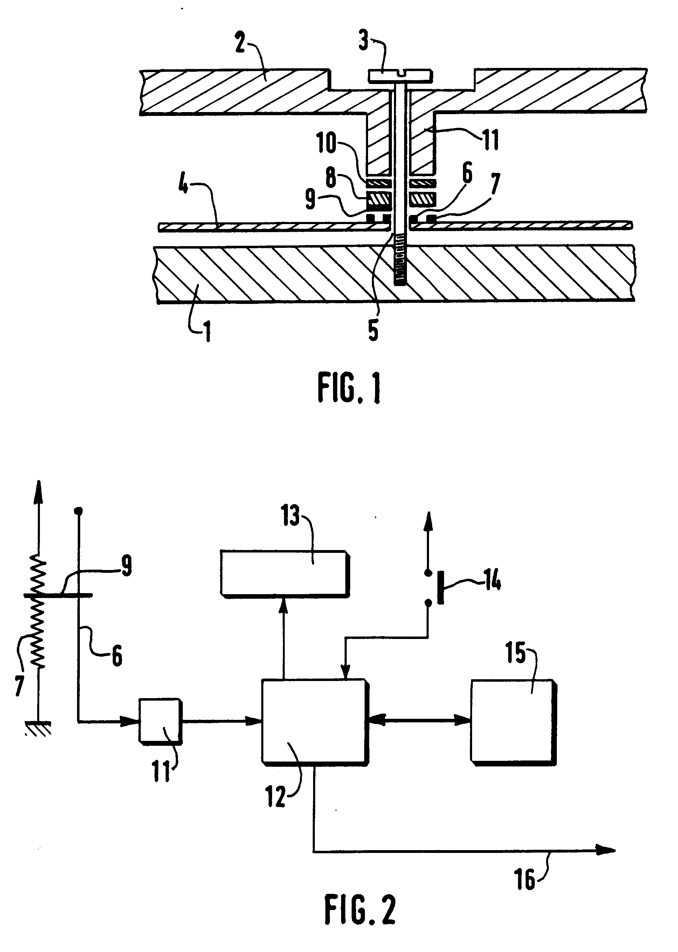

On voit sur la figure 1 un appareil tel qu'un compteur électrique comportant un boîtier 1 et un capot de fermeture 2, maintenu sur le boîtier par une vis 3.

Le capot 2 abrite des organes auxquels peuvent avoir accès des personnes autorisées, par exemple pour la mise en service de l'appareil ou la programmation de certains de ses paramètres, relatifs par exemple à la tarification ou au courant maximum admissible dans le cas d'un compteur électrique.

Un circuit imprimé 4 est solidaire du boîtier 1 et est perçé d'une ouverture 5 pour permettre sa traversée par la vis 3.

Une piste conductrice 6, par exemple en cuivre, et une piste résistive 7, par exemple en carbone, sont formées sur le circuit imprimé 4 autour de l'ouverture 5.

Deux rondelles sont montées sur l'axe de la vis 3.

Une première rondelle 8 réalisée en matériau isolant est en contact avec le circuit 4 et comporte une barrette conductrice radiale 9 qui, lorsque le capot est verrouillé, relie un point de la piste 6 à un point de la piste 7. La deuxième rondelle 10 est disposée entre la rondelle 8 et une face d'extrémité d'un manchon 11 solidaire du capot 2 et traversé par la vis 3.

La figure 2 montre que la piste résistive 7 a une de ses extrémités à la masse et l'autre a une tension fixe. La position de la barrette 9, et par conséquent la position angulaire de la rondelle 8, est déterminée par le potentiel de la piste conductrice 6.

Ce potentiel est converti dans un convertisseur analogique-numérique 11 relié à l'entrée d'un microprocesseur 12.

Le microprocesseur 12 est relié pour sa programmation à un écran 13, par exemple à cristaux liquides, et à un organe 14 tel qu'un bouton poussoir ou un clavier.

Le microprocesseur 12 est également relié à une mémoire 15 par exemple du type EEPROM ainsi qu'à une ligne de transmission 16 vers un poste central.

Lors de la mise en service de l'appareil, après sa programmation, un processus d'initialisation lit la tension sur la piste 6 et la mémorise dans la mémoire 15.

Cette tension est ensuite relue à intervalles réguliers et comparée à la tension mémorisée par le microprocesseur 12.

Lorsque la différence entre la tension lue et la tension mémorisée dépasse un certain seuil, ce fait est mis en mémoire pour être ultérieurement transmis sur la ligne 16 lorsque l'appareil sera consulté à partir du poste central.

On remarque que, grâce au dispositif de l'invention, toute ouverture du capot de l'appareil sera détectée, même si l'appareil a été préalablement mis hors tension.

## Revendications

1. Dispositif pour la détection de l'ouverture d'un appareil comportant un boîter (1) et un capot de fermeture (2) maintenu sur le boîtier par un organe de verrouillage (3) tel qu'une vis, caractérisé par le fait qu'il comprend une rondelle (8) agencée pour être disposée autour de l'organe de verrouillage, des moyens de détection (6,7) de la position angulaire de la rondelle, des moyens de mémorisation (15) de ladite position, des moyens de comparaison (12) entre la position actuelle de la rondelle et sa position mémorisée, et des moyens de signalisation (16) d'une différence entre ladite position actuelle et ladite position mémorisée.

2. Dispositif selon la revendication 1, dans lequel lesdits moyens de détection comprennent une piste résistive (7) sensiblement circulaire, coaxiale à l'organe de verrouillage et solidaire du boîtier, ladite rondelle étant réalisée en matériau isolant et étant, en position de fermeture de l'appareil, en contact avec ladite piste, des moyens pour établir une tension électrique entre les extrémités de ladite piste résistive, et des moyens de mesure (6,9) pour mesurer le potentiel d'un point angulairement déterminé de la rondelle en contact avec la piste résistive.

3. Dispositif selon la revendication 2, dans lequel lesdits moyens de mesure comprennent une piste conductrice (6) coaxiale à, et solidaire de la piste résistive, une barrette conductrice (9) radiale solidaire de la rondelle, agencée pour établir une connexion électrique entre un point de la piste résistive et un point de la piste conductrice, et des moyens (11,12) pour déterminer la différence de potentiel entre la piste conductrice et une extrémité de la piste résistive.

4. Dispositif selon l'une quelconque des revendications 1 à 3, comprenant une deuxième rondelle (10) en contact avec la première rondelle pour établir un frottement aléatoire lors de la rotation de l'organe de verrouillage.

5. Dispositif selon l'une quelconque des revendications 2 et 3, dans lequel lesdites pistes sont formées sur un circuit imprimé (4).
